# EUROPEAN PATENT APPLICATION

(11) **EP 1 802 164 A1**
(43) Date of publication of application: **27.06.2007**
(21) Application number: 05783231.3
(22) Date of filing: 14.09.2005
(51) Int. Cl.: H04R 3/00, H03F 1/02, H04R 19/01

(54) **SIGNAL AMPLIFYING CIRCUIT AND ACCELERATION SENSOR HAVING THE SAME**

(30) Priority: 24.09.2004 JP 2004277901
(71) Applicant: HOSIDEN CORPORATION, Yao-shi, Osaka 581-0071 (JP)
(72) Inventor: SUGIMORI, Yasuo c/o Hosiden Corporation, Yao-shi, Osaka 5810071 (JP)
(74) Representative: Kaiser, Magnus
(86) International application number: PCT/JP2005/016940
(87) International publication number: WO 2006/033269

(57) **Abstract**

A signal amplifying circuit having a small-scale circuit arrangement with low power consumption is provided without degrading detection accuracy by a capacitance detecting element. The circuit comprises an AC-coupled amplifier 2, a voltage generating circuit 3 for generating a bias voltage V1 acting as a reference for AC coupling, and a transmitting device R4 for transmitting the bias voltage V1 to the amplifier 2. A minute voltage signal outputted from the capacitance detecting element 1 is superimposed on the bias voltage V1 as an AC component for amplification. The signal amplifying circuit as arranged above has the following characteristic feature. The circuit is designed so that the input impedance of the transmitting device R4 viewed from the capacitance detecting element 1 is higher than the output impedance of the capacitance detecting element 1.

## Description

### TECHNICAL FIELD

The present invention relates to a signal amplifying circuit comprising an AC coupled signal amplifier, a voltage generating circuit for generating a DC bias voltage acting as a reference of AC coupling, and a transmitting member for transmitting the bias voltage to the amplifier, wherein a minute voltage signal outputted from a capacitance detecting element is superimposed on the bias voltage as an AC component for amplification. The invention also relates to an acceleration sensor including the capacitance element in the form of an electret condenser, and provided with the signal amplifying circuit noted above.

### BACKGROUND ART

In many cases, output is fetched from a capacitance element such as an electret condenser used in microphones, for example, by biasing the gate of an FET (field effect transistor) to OV (zero volt). In such a circuit, a saturation current (drain current) in time of OV average gate-source voltage continues to flow to the drain of the FET. The saturation current normally is in the order of 100 to 500µA (micro ampere). As a result, power consumption becomes a serious problem when microphones, vibration sensors, acceleration sensors or the like using the electret condenser are applied to mobile-type battery-driven devices including mobile phones, pedometers and so on.

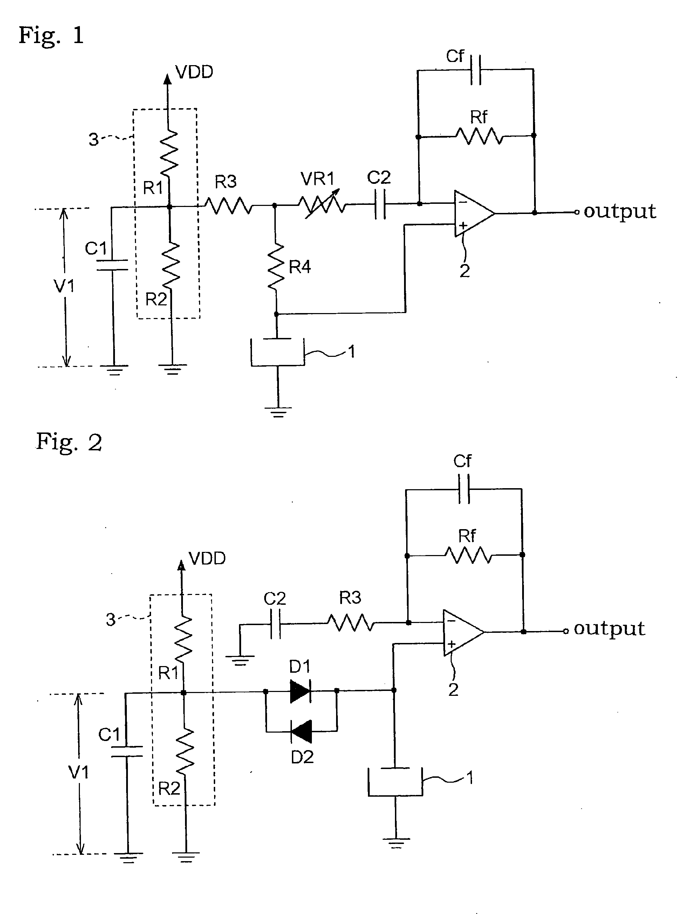

To solve such a problem, Patent Document 1, for example, proposes a drive circuit for an electret condenser microphone comprising a current control device for switching a drain current in response to a timing pulse, and a pulse generator for generating the timing pulse. This drive circuit switches a power supply line to an FET between an electrically connected state and a non-connected state in response to the timing pulse. And, a drain output voltage generated when a voltage is applied to the drain is detected, and the drain voltage is maintained in a level hold circuit when the application of the voltage to the drain is stopped. When a voltage waveform quantized by the timing pulse is obtained in this way, a band limitation is applied to the amplifying circuit, as necessary, to shape a stepped waveform into a continuous waveform. The current flows to the FET only when a voltage is applied thereto. Therefore, if, for example, a time period for applying the voltage is one hundredth of a non-application time period, the average current also becomes one hundredth, and thus current consumption is drastically reduced.
Patent Document 1: Japanese Application "Kokai" No. 2002-232997 (see paragraphs 0014 to 0026, Figs. 1 to 3)

### DISCLOSURE OF THE INVENTION

### PROBLEM TO BE SOLVED BY THE INVENTION

However, when an attempt is made to control power supply by means of the timing pulse as set forth in Patent Document 1, control devices such as a logic circuit and a micro computer for generating the timing pulse are required. In addition, a switching device for switching the power supply on and off is required. Further, although it is possible to shape the quantized and discrete stepped waveform into a continuous waveform by applying a band limitation, the information on variations of the capacitance detected by the capacitance detecting element is unavailable when the power supply is cut. As a result, the detection accuracy of the capacitance detecting element is lost at the side of the drive circuit. When applied to a microphone, for example, the sound quality of a sound signal will be low, and when applied to a vibration sensor or an acceleration sensor, detection accuracy will become low.

The object of the present invention, having regard to the above-noted problems, is to provide a signal amplifying circuit having a small-scale circuit arrangement with low power consumption without degrading detection accuracy of a capacitance detecting element.

### MEANS FOR SOLVING THE PROBLEM

In order to fulfill the above-noted object, a signal amplifying circuit according to the present invention is characterized by comprising an AC-coupled amplifier, a voltage generating circuit for generating a DC bias voltage acting as a reference for AC coupling, and a transmitting device for transmitting the bias voltage to the amplifier, the signal amplifying circuit being arranged to superimpose a minute voltage signal outputted from a capacitance detecting element on the bias voltage as an AC component for amplification, and having the following construction.
That is, an input impedance viewed from the capacitance detecting element is higher than an output impedance of the capacitance detecting element.

With this arrangement, since the output from the capacitance detecting element is fetched for amplification without using an FET (field effect transistor), there occurs no drain current of normally around 100 to 500µA. Thus, the signal amplifying circuit of low power consumption can be realized. Also, the input impedance of the transmitting device viewed from the capacitance detecting element for outputting the minute voltage signal is made higher than the output impedance of the capacitance detecting element. Thus, it is possible to restrain attenuation of the minute voltage signal which is capacitive and has high output impedance. As a result, the signal amplifying circuit having a small-scale circuit arrangement with lower power consumption is realized.

The signal amplifying circuit according to the present invention may be arranged as follows.
The amplifier is an operational amplifier having an output terminal, a feedback input terminal for receiving a feedback signal from the output terminal, and a signal input terminal for receiving the bias voltage with the minute voltage signal superimposed thereon, and is arranged to amplify an input signal by feedback control effected to produce no potential difference between the two input terminals,
The transmitting device includes a resistor having one end connected to the voltage generating circuit and to one of the input terminals through an AC-coupled capacitor, and the other end connected to the signal input terminal and an output terminal of the capacitance detecting element.
The resistor is controllably interlocked with the feedback control to produce no potential difference between opposite ends of the resistor, thereby to undergo an impedance conversion to have high impedance regardless of a value of resistance.

The operational amplifier is an element having a very high input impedance with very low power consumption. Thus, it is possible to considerably reduce the current consumption of normally 100 to 500µA in the circuit using an FET to several µA or several tens of µA. The operational amplifier follows variations of the minute vibration signal (AC component) outputted from the capacitance detecting element based on the property of virtual short to effect feedback control such that no potential difference occurs between the two input terminals. The resistor (transmitting circuit) for transmitting the bias voltage connects the two input terminals of the operational amplifier through the AC-coupled condenser in an AC operation. However, no potential difference is produced between the input terminals as noted above. As a result, no potential difference occurs between the opposite ends of the resistor for transmitting the bias voltage as well, and thus no current flows to the resistor. More particularly, the resistor acting as the transmitting circuit is converted to a circuit having a very high impedance regardless of the value of resistance the resistor has. Consequently, the input impedance of the transmitting device viewed from the capacitance detecting element becomes higher than the output impedance of the capacitance detecting element, thereby to restrain attenuation of the minute voltage signal.

The signal amplifying circuit according to the present invention may be further arranged as follows.
The amplifier is an operational amplifier having an output terminal, a feedback input terminal for receiving a feedback signal from the output terminal, and a signal input terminal for receiving the bias voltage with the minute voltage signal superimposed thereon, and is arranged to amplify an input signal by feedback control effected to produce no potential difference between the two input terminals,
The transmitting device includes a high resistance circuit having one end connected to the voltage generating circuit, and the other end connected to the feedback input terminal and to an output terminal of the capacitance detecting element.

Where the transmitting device includes a high resistance circuit, particularly a high resistance circuit having impedance higher than the output impedance of the capacitance detecting element, it is possible to restrain attenuation of the minute voltage signal outputted from the capacitance detecting element. In other words, the input impedance of the transmitting device viewed from the capacitance detecting element becomes higher than the output impedance of the capacitance detecting element, which can restrain attenuation of the minute voltage signal.

With this arrangement, the high resistance circuit may include two rectifying elements connected to each other in parallel, each having a forward direction counter to the other.

The diode has a forward voltage of 0.6V to 0.7V between its terminals not only in the reverse direction but also in the forward direction. Therefore, no current flows even if the diode is directed forward as long as no potential difference exceeding the forward voltage is produced. Since the minute voltage signal outputted from the capacitance detecting element ranges from several mV to several tens of mV, no current flows to the diodes. As a result, a high resistance circuit having a very high impedance can be realized using the diodes.

Further, the high resistance circuit may comprise a high resistance resistor.

Conventionally, it has been unrealistic in terms of cost and mounting space to apply to a small signal circuit any resistors other than resistor of up to several tens of M (Mega) ohms. However, high resistance resistors of several G (Giga) ohms to several tens of G ohms have recently been put to practical use. The use of such high resistance resistors can realize a small-scale circuit, compared with the parallel-connected circuit of the diodes noted above. In addition, such an arrangement can achieve space-saving and a cost reduction.

Further, in addition to the characteristic features noted above, the signal amplifying circuit may be characterized by comprising a guard ring pattern surrounding wiring mounted on a circuit board for connecting the signal input terminal of the operational amplifier, the output terminal of the capacitance detecting element, and the other end of the transmitting device, the guard ring pattern being connected as follows.
That is, the guard ring pattern is connected to the feedback input terminal of the operational amplifier, or the guard ring pattern is connected to one end of the transmitting device.

In the circuit of signal amplifier circuit according to the present invention, the circuit connected to the other input terminal of the operational amplifier, the output terminal of the capacitance detecting element, and the other end of the transmitting device is a high impedance circuit. Thus, even a slight leak current of several pA sometimes results in a voltage drop and attenuation of the signal.
The signal amplifying circuit of the present invention is embodied in a printed-circuit board or the like. Thus, when dust or dirt adheres to a surface of the board with parts mounted thereon and absorbs moisture, a leak current may sometimes occur on the surface of the board. The leak current flows between a low impedance circuit including the ground, a source power voltage, an output signal of the operational amplifier and the like, and a high impedance circuit.
With the above-noted arrangement, the guard ring pattern provided to surround the high impedance circuit is designed to guard the leak current tending to flow between the low impedance circuit and the high impedance circuit. The guard ring pattern is connected to a wiring pattern of the feedback input terminal for receiving the output signal from the operational amplifier being fed back. The operational amplifier has a property for allowing execution of a deep feed back. Therefore, even if leak current flows to the guard ring pattern connected to the feedback input terminal, feedback control is executed without being subjected to this influence so that the two input terminals may satisfy the relationship of virtual short.
As a result, the feedback input terminal, the guard ring pattern and the signal input terminal are maintained at the same potential. Thus, the high impedance circuit and the guard ring pattern are at the same potential to prevent a leak current from flowing therebetween. Consequently, the high impedance circuit is substantially free from the influence of leak current.
A similar consideration can be given when the guard ring pattern is connected to a wiring pattern of one end of the transmitting device receiving the bias voltage. Since the bias voltage is transmitted to the high impedance circuit, a current hardly flows to the transmitting device. Therefore, only a very small potential difference is produced before and after a minute voltage signal is superimposed, that is across the transmitting device, and the high impedance circuit and the guard ring pattern may be considered to have substantially the same potential. Hence, a leak current is similarly restrained from being generated between the high impedance circuit and the guard ring pattern.

Still further, it is possible to constitute an acceleration sensor including the capacitance detecting element formed of an electret condenser and provided with the signal amplifying circuit according to the present invention having the above-noted arrangement.

When a compact acceleration sensor of low power consumption is intended, it is preferable to employ an arrangement of the electret condenser type (ECM type). More particularly, it is possible to effectively detect variations of capacitance using an electret condenser without applying a large bias voltage in detecting the capacitance. Further, since a compact acceleration sensor of low power consumption is often provided in battery-driven devices, it is possible to realize the acceleration sensor having a small-scale circuit arrangement with low power consumption without degrading the detection accuracy by the capacitance detecting element (ECM) when provided with the signal amplifying circuit in each arrangement according to the present invention.

### BEST MODE FOR CARYYING OUT THE INVENTION

Embodiments of the present invention will be described hereinafter with reference to the drawings.
A signal amplifying circuit according to the present invention is applicable to systems, devices, circuits and the like such as microphones, vibration sensors, acceleration sensors and so on that include a capacitance detecting element for outputting a minute voltage signal. In the embodiment described below, a sensor of the electret condenser microphone type (ECM type) is used as the capacitance detecting element for outputting the minute voltage signal.

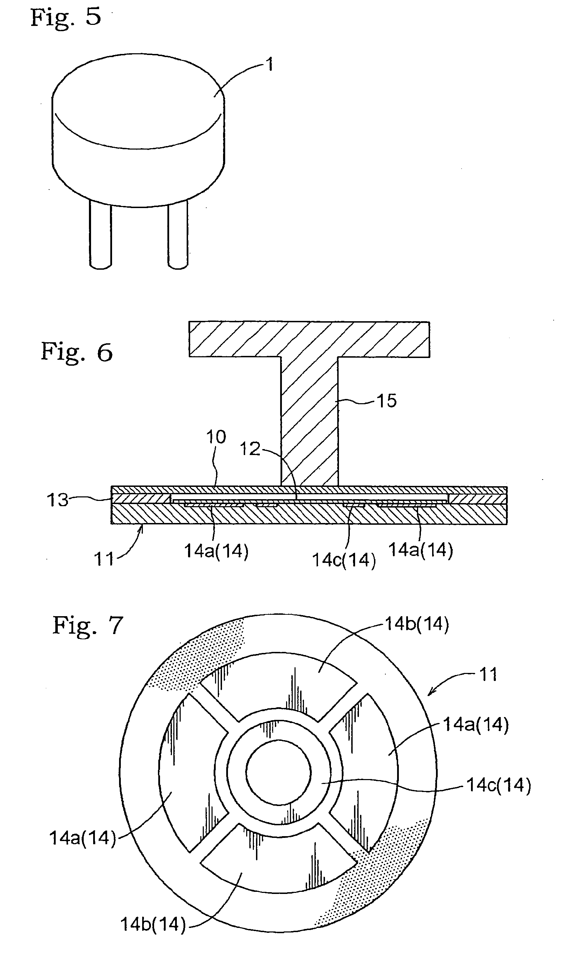

As shown in Fig. 5, for example, this sensor comprises a cylindrical casing body having two terminals. As shown in Fig. 6, the casing body includes therein a diaphragm 10 or a diaphragm membrane the like acting as a movable electrode, and an electrode substrate 11 the like acting as a fixed electrode 14. At least either one of the diaphragm 10 and the fixed electrode 14 has an electret layer 12. Variations of the capacitance between the electrodes spaced from each other by a spacer 13 are outputted as minute voltage signals. In the instance shown in Fig. 6, the fixed electrode 14 is not projected from or caved into the electrode substrate 11, but is formed as embedded in the electrode substrate 11 in order to form the electret layer 12 uniformly.
This sensor may act as a vibration sensor or an acceleration sensor for detecting vibrations when the diaphragm 10 has a weight 15 for receiving shocks or vibrations applied from outside the sensor. Alternatively, the sensor may act as a sound sensor (microphone) for detecting sound signals when the casing body has a sound hole to vibrate the diaphragm with vibrations of air.

In an arrangement similar to the vibration sensor, the direction of displacement of the diaphragm 10 can also be detected when, as shown in Fig. 7, the fixed electrode 14 provided in the electrode substrate 11 is divided. With this arrangement, the sensor acts as a three-axis acceleration sensor. In Fig. 7, the electrodes 14a and 14b act as fixed electrodes for detecting acceleration in a so-called X-Y direction. The central electrode 14c acts as a fixed electrode for detecting acceleration in a so-called Z direction perpendicular to the X-Y direction.

The present invention may be applied to any signal amplifying circuit for amplifying outputs from various sensors as noted above. Particularly, when the signal amplifying circuit according to the present invention is applied to the three-axis acceleration sensor, the amplifying circuit required for each of the three axes can be designed to have a small-scale circuit arrangement with low power consumption, without degrading detection accuracy.

### [First Embodiment]

Fig. 1 is a circuit diagram showing a first embodiment of the signal amplifying circuit according to the present invention. The signal amplifying circuit is designed to amplify, with an operational amplifier 2, an output signal from a sensor portion 1 of the ECM type acting as the capacitance detecting element. As illustrated, the circuit comprises the operational amplifier 2 AC-coupled through a capacitor C2, a voltage generating circuit 3 for generating a DC bias voltage V1 acting as a reference for AC coupling, and a resistor R4 acting as transmitting means for transmitting the bias voltage V1 to the operational amplifier 2. A minute voltage signal is superimposed on the bias voltage V1 as an AC component for amplification. In the present embodiment, the operational amplifier 2 is a CMOS operational amplifier of the low current consumption type.

It should be noted that the sensor portion 1 is a capacitive element and its output is a minute voltage output. More particularly, a strong current cannot be outputted, and the output is of high impedance with a great inner resistance of approximately several G ohms. If such output were connected to a circuit of low impedance, the output voltage from the sensor portion 1 would be attenuated by resistive voltage division of the high impedance and low impedance. In order to restrain this, an impedance conversion is performed so that the input impedance of the resistor R4 (transmitting means) viewed from the sensor portion 1(capacitance detecting element) may be higher than the output impedance of the sensor portion 1. A detailed operation of the circuit will be set forth below as divided into a DC operation and an AC operation. An inverting input terminal (-terminal) of the operational amplifier 2 corresponds to the feedback input terminal of the present invention, while a non-inverting input terminal (+terminal) corresponds to the signal input terminal of the present invention.

### [DC Operation]

The DC operation of the signal amplifier circuit according to the present embodiment will be described first. The bias voltage V1 which is a half of the voltage between power source VDD and ground is generated by the voltage generating circuit 3 through resistive voltage division by the resistors R1 and R2. The bias voltage V1 is a signal of a DC component, and thus direct input to the inverting input terminal (-terminal) of the operational amplifier 2 is blocked by the capacitor C2. On the other hand, the bias voltage V1 is applied to the non-inverting input terminal (+terminal) through the resistors R3 and R4. Since the input impedance of the operational amplifier 2 is very high, current hardly flows through the resistors R3 and R4, and the bias voltage V1 having undergone the resistive voltage division is applied to the non-inverting input terminal. In the DC operation, the feedback of the output from the operational amplifier 2 is blocked by the capacitor C2 in a manner similar to the above, and thus the voltage fed back from the output terminal is inputted only to the inverting input terminal. Therefore, the operational amplifier 2 acts as a voltage follower in the DC operation, and the bias voltage V1 = VDD/2 is outputted from the output terminal. It should be noted that the value of the bias voltage V1 is not limited to the value in this embodiment, but may be varied as appropriate.

### [AC Operation]

An output signal from the sensor portion 1 acting as a vibrating signal, i.e. a signal of an AC component, is inputted to one end of the resistor R4 and the non-inverting input terminal of the operational amplifier 2, as shown in Fig. 1. The operational amplifier 2 has a very high input impedance ranging from several hundred G ohms to several T (Tera) ohms, for example. This is sufficiently greater than the output impedance (several G ohms) of the sensor portion 1 noted above, and thus the output voltage from the sensor portion 1 is inputted without being attenuated by the influence of the input terminal of the operational amplifier 2.

The output voltage from the operational amplifier 2 is led to the inverting input terminal through a resistor Rf and a capacitor Cf of a feedback circuit. The voltages at the inverting input terminal and non-inverting input terminal are controlled to be the same potential due to the property of virtual short inherent in the operational amplifier 2. In the frequency of the output signal from the sensor portion 1 acting as a signal of the AC component, a circuit constant is selected so that the impedance of the capacitor C2 and a variable resistor VR1 may be low. As a result, the potential at the inverting input terminal becomes equal to the potential of the other end of the resistor R4 (namely the terminal opposite to the one end thereof connected to the sensor portion 1). In other words, it becomes equal to the potential of the output signal of the sensor portion 1, and thus no current flows to the resistor R4.

As a result, the resistor R4 normally having a value of resistance of around 10M ohms, for example, has a very large impedance of several tens of G ohms or more viewed from the sensor portion 1 regardless of the circuit constant. More particularly, an impedance conversion is executed so that the input impedance of the resistor 4 acting as the transmitting means viewed from the sensor portion 1 may be greater than the output impedance of the sensor portion 1 acting as the capacitance detecting element. As a result, the voltage signal outputted from the sensor portion 1 is restrained from being attenuated.

It should be noted that the bias voltage V1 superimposed by the amplified signal voltage of the sensor portion 1 is outputted from the output terminal of the operational amplifier 2. The combination of the capacitor Cf and the resistor Rf forms a low-pass filter. An undesired high frequency wave constituting a noise component is removed by this filter. Also, it is possible to operate the variable resistor VR1 to change the value of resistance, thereby to vary the impedance of the resistor R4 viewed from the sensor portion 1 generally represented by (R3x R4)/VR1, to vary the output amplitude of the operational amplifier 2.

### [Second Embodiment]

Fig. 2 is a circuit diagram showing a second embodiment of the signal amplifying circuit according to the present invention. This signal amplifying circuit also is designed to amplify the output signal from the sensor portion 1 of the ECM type with an operational amplifier 2. As illustrated, the circuit comprises the operational amplifier 2 AC-coupled through a capacitor C2, and a voltage generating circuit 3 for generating a DC bias voltage V1 acting as a reference for AC coupling. The circuit further comprises diodes (rectifying devices) D1 and D2 in parallel connection, each having a forward direction counter to the other, to act as transmitting means for transmitting the bias voltage V1 to the operational amplifier 2. A minute voltage signal outputted from the sensor portion 1 acting as the capacitance detecting element is superimposed as an AC component on the bias voltage V1 for amplification. In the present embodiment as well, the operational amplifier 2 is a CMOS operational amplifier of the low power consumption type. The inverting input terminal (-terminal) of the operational amplifier 2 corresponds to the feedback input terminal of the present invention while the non-inverting input terminal (+terminal) corresponds to the signal input terminal of the present invention. Further, the parallel-connected diodes D1 and D2, each having the forward direction counter to the other, correspond to the high resistance circuit of the present invention.

### [DC Operation]

A DC operation of the signal amplifier circuit according to the present invention will be described first. A voltage which is a half of the voltage between power source VDD and ground is generated by the voltage generating circuit 3 through resistive voltage division by the resistors R1 and R2. This voltage is connected to the non-inverting input terminal (+terminal) of the operational amplifier 2 through one of the diodes, diode D1, to represent the bias voltage V1. The other of the diodes, diode D2, is connected in a reverse direction to the diode D1 in order to prevent overvoltage of the non-inverting input terminal of the operational amplifier 2. Generally, the diode has a forward voltage of around 0.6 V to 0.7 V in the forward direction. However, a current hardly flows through the diode D1, and thus the voltage of VDD/2 (bias voltage V1) generated by the voltage generating circuit 3 is applied as it is to the non-inverting input terminal of the operational amplifier 2. The feedback of the output from the operational amplifier 2 is blocked by the capacitor C2, and thus directed only to the inverting input terminal. Therefore, in the DC operation, the operational amplifier 2 acts as a voltage follower to output the bias voltage V1. The voltage value of the bias voltage V1 is not limited to the value in this embodiment, but may be varied as appropriate.

### [AC Operation]

An output signal from the sensor portion 1 acting as a vibrating signal, i.e. a signal of an AC component is inputted to a cathode terminal of the diode D1, an anode terminal of the diode D2, and the non-inverting input terminal of the operational amplifier 2, as shown in Fig. 2. As noted above, the operational amplifier 2 has a very high input impedance which is, for example, 1 T ohm in the present embodiment. On the other hand, the output voltage from the sensor portion 1 is minute, ranging from several mV to several tens of mV, which never exceeds not only the reverse breakdown voltage of the diodes D1 and D2 but also the forward voltage of the diodes D1 and D2. Therefore, both the diodes D1 and D2 are non-conductive to have high impedance. Thus, the output voltage from the sensor portion 1 is inputted to the operational amplifier 2 without being attenuated by the influence of the input terminal of the operational amplifier 2. It is preferable to select the diodes D1 and D2 both having a small capacitance between the terminals in order not to affect the output of the sensor portion 1.

The output voltage from the operational amplifier 2 is led to the inverting input terminal by the resistor Rf and the capacitor Cf of the feedback circuit, while the AC component is led to the ground through the resistor R3. And, acting as a non-inverting amplifier, the operational amplifier 2 outputs a voltage having, superimposed thereon the signal voltage of the sensor portion 1 amplified to the bias voltage V1.

The combination of the capacitor Cf and the resistor Rf forms a low-pass filter. An undesired high frequency wave constituting a noise component is removed by this filter. On the other hand, the capacitor C2 and the resistor R3 constitute a high-pass filter in combination with the operational amplifier 2. Therefore, a circuit constant is selected so that the signal from the sensor portion 1 may not be attenuated. Also, when part of the resistor R3 is changed to a variable resistor, the value of resistance can be varied by operating the variable resistor, thereby to change an amplification factor generally represented by 1 + Rf/R3.

### [Third Embodiment]

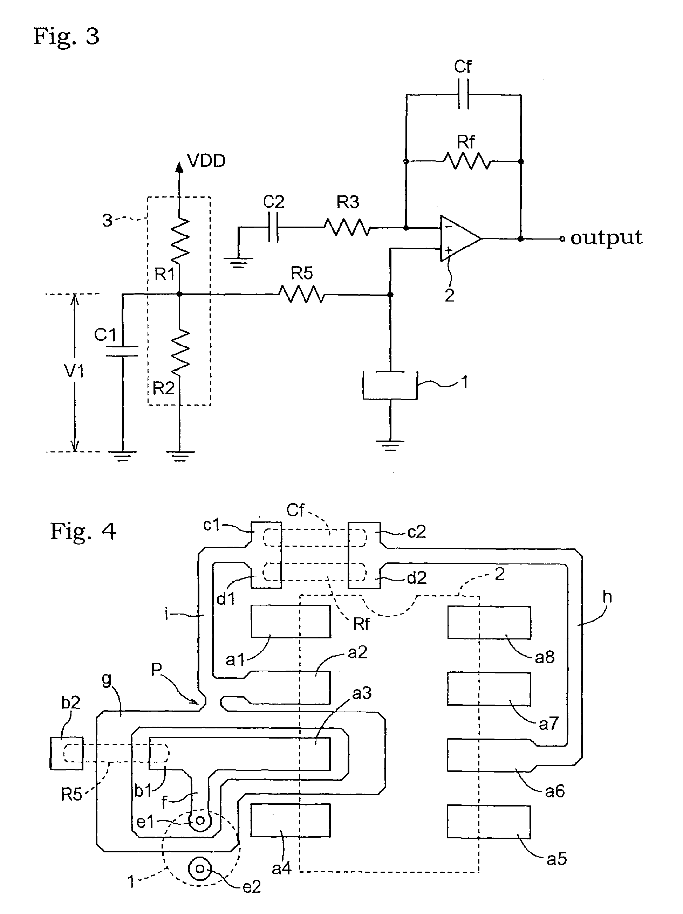

Fig. 3 is a circuit diagram showing a third embodiment of the signal amplifying circuit according to the present invention. As in the second embodiment, the circuit comprises an operational amplifier 2 AC-coupled through a capacitor C2, and a voltage generating circuit 3 for generating a DC bias voltage V1 acting as a reference for AC coupling. In this third embodiment, a high resistance circuit is provided using a high resistance resistor R5 (which may be referred to as the resistor R5 hereinafter) acting as transmitting means for transmitting the bias voltage V1 to the operational amplifier 2. The resistor R5 has one end connected to the voltage generating circuit 3 and the other end connected to the sensor 1 and the operational amplifier 2 to form the transmitting means. The resistor R5 has a value of resistance of several tens of G ohms. The signal amplifying circuit superimposes a minute voltage signal outputted from the sensor portion 1 acting as the capacitance detecting element on the bias voltage V1 as an AC component for amplification. In the present embodiment as well, the operational amplifier 2 is a CMOS operational amplifier of the low power consumption type. The inverting input terminal (-terminal) of the operational amplifier 2 corresponds to the feedback input terminal of the present invention, while the non-inverting input terminal (+terminal) corresponds to the signal input terminal of the present invention.

### [DC Operation]

As in the second embodiment, a voltage which is a half of the voltage between power source VDD and ground is generated by the voltage generating circuit 3 through resistive voltage division by the resistors R1 and R2. This voltage is connected to the non-inverting input terminal (+terminal) of the operational amplifier 2 through the resistor R5 to represent the bias voltage V1. The feedback of the output of the operational amplifier 2 is blocked by the capacitor C2, and is thus directed only to the inverting input terminal. Therefore, in the DC operation, the operational amplifier 2 acts as a voltage follower to output the bias voltage V1. The voltage value of the bias voltage V1 is not limited to the value in this embodiment, but may be varied as appropriate.

### [AC Operation]

An output signal from the sensor portion 1 acting as a signal of an AC component is inputted to the other end of the resistor R5 and the non-inverting input terminal of the operational amplifier 2, as shown in Fig. 3. As noted above, the operational amplifier 2 has a very high input impedance which is around 1 T ohm, for example. On the other hand, the resistor R5 has a high resistance of about several tens of G ohms. Similarly, the input impedance of the transmitting means viewed from the sensor portion 1 is very high. Thus, the output voltage from the sensor portion 1 is inputted to the operational amplifier 2 without being attenuated by the influence of the input terminal of the operational amplifier 2.
Conventionally, it has been unrealistic in terms of cost and mounting space to apply to a small signal circuit any resistors other than resistors of up to several tens of M ohms. However, high resistance resistors of several G ohms to several tens of G ohms have recently been put to practical use. The use of such high resistance resistors can realize a small-scale circuit, compared with the parallel-connected diode circuit noted above. In addition, such an arrangement can achieve space-saving and a cost reduction.

### [Countermeasure against Leak Current]

In the signal amplifying circuit shown in Fig. 3, the circuit connected to the other input terminal of the operational amplifier 2 (non-inverting input terminal in Fig. 3), the output terminal of the sensor portion 1 and the resistor R5 is a high impedance circuit. Thus, even a slight leak current of several pA sometimes results in a large voltage drop and attenuation of the signal.
The signal amplifying circuit is embodied in a printed-circuit board or the like. Thus, when dust or dirt adheres to a surface of the board with parts mounted thereon, and absorbs moisture, a leak current may sometimes occur on the surface of the board. The leak current flows between a low impedance circuit including the ground, a source power voltage, an output signal of an operational amplifier and the like, and a high impedance circuit.

In view of this, as a countermeasure against leak current, a guard ring pattern is provided to surround wiring on the circuit board connected to the non-inverting input terminal of the operational amplifier 2, the output terminal of the sensor portion 1 and the resistor R5 in the circuit shown in Fig. 3. The guard ring pattern is designed to guard the high impedance circuit from a leak current tending to flow between the low impedance circuit and the high impedance circuit. The guard ring pattern is connected to the inverting input terminal of the operational amplifier 2. Alternatively, the guard ring pattern is connected to the terminal of the resistor 5 which is opposite to the above (terminal adjacent the output side of the voltage generating circuit 3).

Where the guard ring pattern is connected to a wiring pattern of the inverting input terminal (feedback input terminal) of the operational amplifier 2, even if the guard ring pattern absorbs the leak current, the operational amplifier 2 executes feedback control without being subjected to this influence so that the two input terminals may satisfy the relationship of virtual short.
As a result, the feedback input terminal, the guard ring pattern and the signal input terminal are maintained at the same potential. Thus, the high impedance circuit and the guard ring pattern are at the same potential to prevent the leak current from flowing therebetween. Consequently, the high impedance circuit is substantially free from the influence of the leak current.

A similar consideration can be given when the guard ring pattern is connected to the wiring pattern of the output of the voltage generating circuit 3. Since the bias voltage V1 is transmitted to the high impedance circuit, a current hardly flows to the transmitting means (resistor R5). Therefore, no substantial potential difference is produced before and after the minute voltage signal is superimposed, that is across the resistor R5. The high impedance circuit and the guard ring pattern reach substantially the same potential. Hence, as in the same manner as the above, the high impedance circuit is guarded by the guard ring pattern from the influence of the leak current. Where the voltage generating circuit 3 is a constant voltage circuit, the high impedance circuit and the guard ring pattern can be maintained at the same potential with increased stability. This is because, even when the guard ring pattern absorbs the leak current, the constant voltage circuit maintains the bias voltage V1 at a constant level without being subjected to this influence.

An embodiment provided with the guard ring pattern will be described next.
Fig. 4 is an explanatory view showing electrode patterns and wiring patterns of the operational amplifier 2, the resistor Rf and capacitor Cf of the feedback circuit, the high resistance resistor R5 acting as the transmitting means for transmitting the bias voltage V1 to the operational amplifier 2, and the signal input from the sensor portion 1.

With this arrangement, the operational amplifier 2 is an 8-pin or 5-pin IC (integrated circuit). The present embodiment employs the 8-pin IC of the surface mounting type as shown. Electrode patterns a1 through a8 correspond to 1-pin through 8-pin of the operational amplifier 2, respectively. The 2-pin of the operational amplifier 2 is the inverting input terminal, the 3-pin the non-inverting input terminal, and the 6-pin the output terminal. The remaining terminals are power source terminals of the power source voltage and the ground, and unused terminals.

Two pairs of electrode patterns c1 and c2 and electrode patterns d1 and d2 are electrode patterns for mounting the capacitor Cf and resistor Rf of the feedback circuit extending from the output terminal (6-pin) to the inverting input terminal (2-pin) of the operational amplifier 2. In the present embodiment, the case of surface mounting parts (chip parts) is shown.
Electrode patterns b1 and b2 represent patterns for mounting the resistor R5 acting as the transmitting means for transmitting the bias voltage V1 to the operational amplifier 2. In the present embodiment, the case of surface mounting parts (chip parts) is shown.

Electrode patterns e1 and e2 having through holes represent electrode patterns connected to the terminals of the sensor portion 1. Lead terminals of the sensor portion 1 having an outer configuration as shown in Fig. 5 are inserted and mounted in the through holes. The electrode pattern e1 represents an electrode pattern for transmitting the signal input from the sensor portion 1.

A wiring pattern h extends to the electrode patterns c2 and d2 from the electrode pattern a6 corresponding to the output terminal of the operational amplifier 2. The output signal from the operational amplifier 2 is transmitted to the electrode patterns c1 and d1 through the capacitor Cf and the resistor Rf from the electrode patterns c2 and d2. The signal from the electrode patterns c1 and d1 is transmitted to the electrode pattern a2 of the inverting input terminal (2-pin) through a wiring pattern i. Thus, the feedback circuit is formed.

The electrode pattern e1 and one of the electrode patterns b1 of the resistor R5 are connected to the electrode pattern a3 of the non-inverting input terminal (3-pin) through a wiring pattern f. Since the wiring pattern f is very sensitive signal wiring, it should be formed as short as possible as shown.

Further, the wiring pattern f is provided with a guard ring pattern g as illustrated. More particularly, the guard ring pattern g is mounted to surround the terminal of the resistor R5 adjacent the operational amplifier 2, the signal output of the sensor portion 1 and the non-inverting input terminal (3-pin) of the operational amplifier 2.

This guard ring pattern g is connected to the wiring pattern of the inverting input terminal (2-pin) at a connecting point P. The inverting input terminal and the non-inverting input terminal are controlled to be the same potential due to the property of virtual short inherent in the operational amplifier 2. As a result, the guard ring pattern g and the high impedance circuit connected to the wiring pattern f have an equal potential. Thus, no current flows between the two patterns. As a result, the operational amplifier 2 can operate stably without being affected by the leak current.

To facilitate illustration and description, wiring patterns of the remaining terminals of the operational amplifier 2 and wiring patterns of the other circuits are omitted. In the above embodiment, the operational amplifier 2, various resistors, capacitor and the like are described as the surface mounting parts, but this is not intended to limit the present invention. Of course, the wiring patterns are not limited to the examples shown. The circuit arrangement using discrete parts or other wiring patterns may be modified as appropriate.

As described above, the present invention can provide a signal amplifying circuit having a small-scale circuit arrangement with low power consumption without degrading the detection accuracy by the capacitance detecting element.

### INDUSTRIAL UTILITY

It is possible to provide accelerate sensors, vibration sensors, sound sensors, microphones and the like comprising a sensor portion with a capacitance element formed of an electret condenser, and provided with a signal amplifying circuit according to the present invention.

### BRIEF DESCRIPTION OF THE DRAWINGS

[Fig. 1]
   Circuit diagram showing a first embodiment of a signal amplifying circuit according to the present invention.
[Fig. 2]
   Circuit diagram showing a second embodiment of the signal amplifying circuit according to the present invention.
[Fig. 3]
   Circuit diagram showing a third embodiment of the signal amplifying circuit according to the present invention.
[Fig. 4]
   Wiring pattern diagram showing an example of a guard ring pattern provided for the circuit shown in Fig. 3.
[Fig. 5]
   Outline view showing an example of a sensor provided with the signal amplifying circuit according to the present invention.
[Fig. 6]
   Sectional view showing a constitutional example of the sensor provided with the signal amplifying circuit according to the present invention.
[Fig. 7]
   Sectional view showing a constitutional example of a three-axis acceleration sensor provided with the signal amplifying circuit according to the present invention.

### DESCRIPTION OF THE REFERENCE SIGNS

- 1: sensor portion (capacitance detecting element)
- 2: operational amplifier (amplifier)
- 3: voltage generating circuit
- R4: resistor (transmitting means)
- V1: bias voltage

## Claims

1. A signal amplifying circuit comprising an AC-coupled amplifier, a voltage generating circuit for generating a DC bias voltage acting as a reference for AC coupling, and a transmitting device for transmitting the bias voltage to the amplifier,
the signal amplifying circuit being adapted to superimpose a minute voltage signal outputted from a capacitance detecting element on the bias voltage as an AC component for amplification,
wherein an input impedance viewed from the capacitance detecting element is higher than an output impedance of the capacitance detecting element.

2. A signal amplifying circuit as defined in Claim 1, wherein the amplifier is an operational amplifier having an output terminal, a feedback input terminal for receiving a feedback signal from the output terminal, and a signal input terminal for receiving the bias voltage with the minute voltage signal superimposed thereon, and is arranged to amplify an input signal by feedback control effected to produce no potential difference between the two input terminals,
wherein the transmitting device includes a resistor having one end connected to the voltage generating circuit and to one of the input terminals through an AC-coupled capacitor, and the other end connected to the signal input terminal and an output terminal of the capacitance detecting element, and
wherein the resistor is controllably interlocked with the feedback control to produce no potential difference between opposite ends of the resistor, thereby to undergo an impedance conversion to have a high impedance regardless of a value of resistance.

3. A signal amplifying circuit as defined in Claim 1, wherein the amplifier is an operational amplifier having an output terminal, a feedback input terminal for receiving a feedback signal from the output terminal, and a signal input terminal for receiving the bias voltage with the minute voltage signal superimposed thereon, and is arranged to amplify an input signal by feedback control effected to produce no potential difference between the two input terminals, and
wherein the transmitting device includes a high resistance circuit having one end connected to the voltage generating circuit, and the other end connected to the feedback input terminal and to an output terminal of the capacitance detecting element.

4. A signal amplifying circuit as defined in Claim 3, wherein the high resistance circuit includes two rectifying elements connected to each other in parallel, each having a forward direction counter to the other.

5. A signal amplifying circuit as defined in Claim 3, wherein the high resistance circuit comprises a high resistance resistor.

6. A signal amplifying circuit as defined in any one of Claims 2 to 5, comprising a guard ring pattern surrounding wiring mounted on a circuit board for connecting the signal input terminal of the operational amplifier, the output terminal of the capacitance detecting element, and the other end of the transmitting device, and wherein the guard ring pattern is connected to the feedback input terminal of the operational amplifier.

7. A signal amplifying circuit as defined in any one of Claims 2 to 5, comprising a guard ring pattern surrounding wiring mounted on a circuit board for connecting the signal input terminal of the operational amplifier, the output terminal of the capacitance detecting element, and the other end of the transmitting device, and wherein the guard ring pattern is connected to the one end of the transmitting device.

8. An acceleration sensor having a signal amplifying circuit as defined in any one of Claims 2 to 5, wherein the capacitance detecting element is formed of an electret condenser.
